# EUROPEAN PATENT SPECIFICATION

(11) **EP 0 435 389 B1**
(45) Date of publication and mention of the grant of the patent: **12.03.1997**
(21) Application number: 90203378.6
(22) Date of filing: 18.12.1990
(51) Int. Cl.: G06F 7/50, H03K 17/693, H03K 19/094, H03K 19/21

(54) **Differential input, differential output BICMOS multiplexers and logic gates and an adder utilizing the same**
BICMOS-Multiplexer und logische Gatter mit Differential-Eingängen und Differential-Ausgängen und ein diese verwendender Addierer
Multiplexeurs et portes logiques BICMOS à entrées et sorties différentielles et un additionneur utilisant ceux-ci

(30) Priority: 28.12.1989 US 458120
(43) Date of publication of application: 03.07.1991
(73) Proprietor: Philips Electronics N.V., 5621 BA Eindhoven (NL)
(72) Inventor: Fletcher, Thomas Dale, NL-5656 AA Eindhoven (NL); Burton, Edward Allyn, NL-5656 AA Eindhoven (NL)
(74) Representative: Strijland, Wilfred

(56) References cited:
- EP-A- 0 058 958
- PATENT ABSTRACTS OF JAPAN vol. 7, no. 288 (E-218)(1433) 22 December 1983 & JP- A-58 165 424
- RESEARCH DISCLOSURE. no. 300, April 1989, HAVANT GB 'RXTENDABLE BICMOS LATCH'

## Description

The present invention relates to devices utilizing bipolar and field effect transistors (FETs). More particularly, the present invention relates to BiCMOS multiplexers and logic gates such as OR/NOR and XOR/XNOR gates which utilize a differential input and which provide a high drive, low delay differential output. The BiCMOS multiplexers and logic gates may be advantageously used in combinations to provide a full adder.

### 2. Background Art

The new technology of BiCMOS which utilizes both bipolar and CMOS transistors in a single device has been increasingly explored in the past few year. The advantage of BiCMOS circuits over conventional CMOS or bipolar circuits is that the high speed characteristic of bipolar circuits can be obtained with an integration density on a low power consumption characteristic of CMOS circuits.

BiCMOS buffers, inverters, and gates are known from European Patent Application No. 058 958, which shows an output stage comprising a bipolar transistor in emitter follower configuration and a grounded source FET coupled to an output. However, the BiCMOS technology has not been commonly applied to multiplexers or to logic gates having structures similar to multiplexers. Also, multiplexers and logic gates with differential input, differential output BiCMOS technology which provides additional speed beyond single output BiCMOS technology heretofore unknown.

Examples of multiplexers of the art include the patent to Best, U.S. #4,417,314 which discloses a CMOS adder circuit providing sum and carry outputs as well as logical AND, OR, XNOR, and XOR outputs, and the application of Adair, PCT publication WO86/07173, which discloses a full adder circuit comprised of simple 2-input gates and a pair of pass transistor multiplexers. Neither disclosure utilizes BiCMOS technology. Also, neither disclosure utilizes a differential input and provides a differential output.

It is therefore an object of the invention to provide a differential input, differential output BiCMOS multiplexer.

It is another object of the invention to provide differential input, differential output BiCMOS logic gates related to the BiCMOS multiplexer.

It is a further object of the invention to provide a full adder utilizing differential input, differential output BiCMOS multiplexers and logic gates.

In accordance with the objects of the invention as defined in claim 1, a differential input, differential output BiCMOS multiplexer is provided. The multiplexer has as inputs thereto: noninverted and inverted inputs of a first differential input; noninverted and inverted inputs of a second differential input; and noninverted and inverted inputs of a differential select input. The multiplexer is arranged to provide signals at its output corresponding to signals at either the first or the second differential input based on the select input.

The multiplexer broadly comprises four single FET pass gates, two bipolar pull-up transistors, two pull-down FETs, and two pull-up FETs. Respective noninverted and inverted inputs of the first and second differential inputs are coupled to respective drains of the four single FET pass gates. The noninverted select input signal is applied to the gates of the FET pass gates which are coupled to one of the differential inputs, and the inverted select input signal is applied to the gates of the FET pass gates coupled to the other of the differential inputs. The sources of the FET pass gates which are coupled to the noninverted inputs are coupled to the base of a first bipolar transistor, while the sources of the FET pass gates which are coupled to the inverted inputs are coupled to the base of a second bipolar transistor. The collectors of both bipolar transistors are coupled to a first voltage rail. The noninverting output for the multiplexer is taken from the emitter of the bipolar transistor coupled to the noninverting inputs, while the inverting output of the multiplexer is taken from the emitter of the bipolar transistor coupled to the inverting inputs. Coupled between the collector and base of each bipolar transistor is a pull-up FET transistor having its source coupled to the collector and its drain coupled to the base. The gate of the pull-up FET transistor coupled to the bipolar transistor providing the noninverting output signal is coupled to the sources of the FET pass gates which are coupled to the inverting inputs. The gate of the pull-up FET transistor having its source coupled to the bipolar transistor providing the inverted output signal is coupled to the sources of the FET pass gates which are coupled to the noninverting inputs. Coupled between the emitters of the bipolar transistors and a second voltage rail are the pull-down FETs, with their drains coupled to the emitters, and their sources coupled to the second voltage rail. The gate of the pull-down FET coupled to the noninverting output has its gate coupled to the sources of the FET pass gates which are coupled to the inverting inputs, while the gate of the pull-down FET coupled to the inverting output has its gate coupled to the sources of the FET pass gates which are coupled to the noninverting inputs.

By coupling the noninverting input of the first differential input to the inverting input of the second differential input, and by coupling the inverting input of the first differential input to the noninverting input of the second differential input, an exclusive OR/ exclusive NOR (XOR/XNOR) gate is created from the multiplexer, where a first of the coupled inputs is a noninverting input and the second of the coupled inputs is an inverting input of a first differential input, and where the differential select input acts as a second differential input. Alternatively, by tying the first FET pass gate to a high voltage rail, the third FET pass gate to a low voltage rail, the noninverting input of the first differential input to the second FET pass gate, and the inverting input of the first differential input to the fourth FET pass gate, an OR/NOR gate is created from the multiplexer when the differential select input acts as a second differential input.

According to another embodiment of the invention, another OR/NOR gate is provided and has first and second differential inputs and a differential (OR/NOR) output. The OR/NOR gate utilizes: two FET pass gates; a FET or bipolar transistor tied to a first voltage rail and a FET transistor tied to a second voltage rail in place of third and fourth FET pass gates; two pull-up bipolar transistors; and two sets of a FET and inverter couple acting as a pull-down.

The OR/NOR gate has the noninverted and inverted inputs of a first differential input coupled to sources of the two FET pass gates, while the source of a third FET is tied to a second voltage rail, and the collector of a bipolar transistor is tied to a first voltage rail. The gate of the FET tied to the second voltage rail and the base of the bipolar transistor tied to the first voltage rail are coupled to the noninverting input of the second differential input. The gates of the FET pass gates are tied to the inverting input of the second differential input. The emitter of the bipolar transistor tied to the first voltage rail and the source of the pass gate FET coupled to the noninverted input of the first differential input are both coupled to the base of a first pull-up bipolar transistor, while the sources of the FET tied to the second voltage rail and the pass gate FET coupled to the inverted input of the first differential input are coupled to the base of a second pull-up bipolar transistor. The noninverting (OR) output of the gate is taken from the emitter of the first pull-up bipolar transistor, while the inverting (NOR) output of the gate is taken from the emitter of the second pull-up bipolar transistor. Both pull-up bipolar transistors have their collectors coupled to the first voltage rail. Coupled between the collector and emitter of each of the pull-up bipolar transistors is a FET and inverter couple, with the source of the FET coupled to the collector, the gate of the FET coupled to the emitter, and the drain of the FET coupled to the base of the other pull-up bipolar transistor. The input of the inverter is also coupled to the drain of that FET, while the inverting output of the inverter is coupled to the gate of that FET.

Two XOR/XNOR gates and a multiplexer can be utilized to provide a full adder with carry in and carry out. A first of the two XOR/XNOR gates receives two differential input signals and provides a first differential output signal. The first differential output signal is used as a first differential input signal to the second XOR/XNOR gate, while the carry in differential input signal is used as a second differential input signal to the second XOR/XNOR gate which provides a second differential output signal. The noninverting output of the second differential output is taken as the sum, while the inverting output is the inverse of the sum. The multiplexer uses the fist differential output signal from the first XOR/XNOR gate as the differential select input signal which multiplexes the second differential input signal and the carry in differential input signal. The noninverting output signal of the multiplexer is taken as the carry out, while the inverting output signal of the multiplexer is the inverse of the carry out.

The multiplexer and gates of the invention are useful for many purposes, including parity checks, DRAM control, and for use in floating point processors, etc.

Additional objects and advantages of the invention will become evident upon reference to the detailed description in conjunction with the provided drawings.
Figure 1 is a circuit diagram of the BiCMOS differential input, differential output multiplexer of the invention;
Figure 2 is a circuit diagram of the BiCMOS differential input, differential output XNOR/XOR gate of the invention;
Figure 3 is a circuit diagram of a first BiCMOS differential input, differential output OR/NOR gate of the invention;
Figure 4 is a circuit diagram of a second BiCMOS differential input, differential output OR/NOR gate of the invention; and
Figure 5 is a circuit diagram of a BiCMOS differential input, differential output one bit full adder with carry in and carry out.

Inverted inputs and outputs are indicated with prime (" ' ") signs in the drawings and the specification.

Before describing the circuits shown in the figures, it should be understood that for purposes of this application, the term "BiCMOS" is used in its broadest sense to refer to circuits having both bipolar transistors and FET transistors, regardless of whether MOSFETs or other types of IGFETs are used or whether both p-channel and n-channel type FETs are utilized in a single circuit. In fact, any description of a transistor as a MOS transistor is intended to be understood in its broadest sense to include other types of IGFETs and not to be limited to metal-gate FETs. Also, it should be understood that while circuits are described as preferably including npn bipolar transistors, if the polarities of the bipolar and MOS transistors are reversed, equivalent functional circuits are obtained. Thus, "pull-up" transistors will become "pull-down" transistors and vice versa. Further, it will be appreciated that while "inputs" and "outputs" to and from the circuit are described, little distinction is provided regarding whether the inputs or outputs are signals or nodes, as those skilled in the art will readily appreciate whether a signal or node is being described.

It should be understood that a pass gate generally has first and second flow electrodes and a control electrode for controlling current flow between the first and second electrodes. These electrodes respectively are first and second source/drain elements and gate electrode when the pass gate is a FET, and these electrodes respectively are collector, emitter, and base when the pass gate is a bipolar transistor.

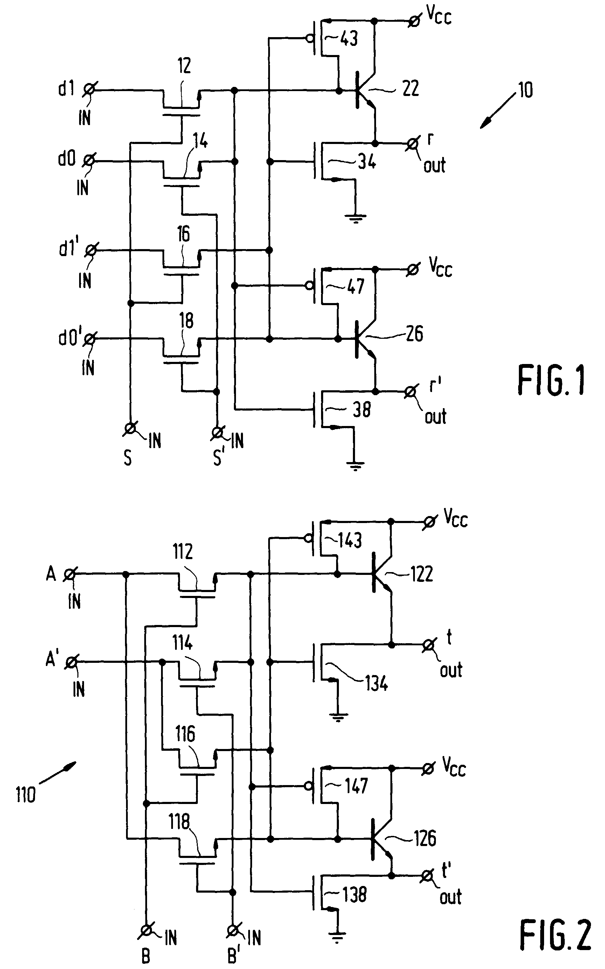

Turning to Figure 1, the BiCMOS differential input, differential output multiplexer 10 of the invention is seen. As shown in Figure 1, the inputs into multiplexer 10 include the noninverted and inverted inputs of two differential inputs (d0, d0', and d1, d1') and the noninverted and inverted inputs of a select input (S, S'). The differential output is shown with noninverted output r, and inverted output r'.

The multiplexer broadly comprises four single nMOS pass gates 12, 14, 16, 18, two npn bipolar transistors 22 and 26, two nMOS transistors 34 and 38, and two pMOS transistors 43 and 47. Inputs d1, d0, d1' and d0' are respectively applied to first source/drain elements of transistors 12, 14, 16, and 18. The noninverted select input S is applied to the gate electrodes of nMOS pass gates 12 and 16, while the inverted select input signal S' is applied to the gate electrodes of nMOS transistors 14 and 18. The second source/drain elements of nMOS transistors 12 and 14 are both coupled to the base of bipolar transistor 22, while the second source/drain elements of nMOS transistors 16 and 18 are both coupled to the base of bipolar transistor 26. For purposes of brevity, reference to source/drain elements hereinafter will be abbreviated to simply the drain or source of the FET based on the polarity of the circuit described, while the gate electrode will be referred to as the gate.

Bipolar transistor 22 is arranged with its collector coupled to the high voltage rail Vcc, and the noninverting output r of the multiplexer 10 is taken from the emitter of the bipolar transistor 22. Coupled across the base-collector junction of bipolar transistor 22 is pMOS transistor 43 with its source coupled to the collector and its drain coupled to the base. The gate of pMOS transistor 43 is coupled to the sources of nMOS pass gates 16 and 18. Also coupled to the gate of pMOS transistor 43 is the gate of nMOS transistor 34. The drain of nMOS transistor 34 is coupled to the emitter of bipolar transistor 22 (i.e. the r output), while the source of nMOS transistor 34 is coupled to the low voltage rail (e.g. ground).

Bipolar transistor 26 is arranged similarly to bipolar transistor 22, with the collector of transistor 26 coupled to the high voltage rail Vcc, and the inverting output r' of the multiplexer 10 taken from the emitter of transistor 26. Coupled across the base-collector junction of bipolar transistor 26 is pMOS transistor 47 with its source coupled to the collector and its drain coupled to the base. The gate of pMOS transistor 47 is coupled to the sources of nMOS pass gates 12 and 14. Also coupled to the gate of pMOS transistor 47 is the gate of nMOS transistor 38. The drain of nMOS transistor 38 is coupled to the emitter of bipolar transistor 26 (i.e. the r' output), while the source of nMOS transistor 38 is coupled to the low voltage rail (e.g. ground).

In operation, the differential select input acts to select one of the differential inputs. When S is high, inputs d1 and d1' are selected, and the signal (i.e. high or low) at the d1 input is generated at the noninverting output r, while the opposite signal at the d1' input is generated at the inverting output r' in the following manner. When S is high, S' is low. Hence, pass gate transistors 12 and 16 are turned on, while pass gate transistors 14 and 18 are off. As a result, the signal from input d1 passes through transistor 12 and is fed to the base of bipolar transistor 22 and to the gate of nMOS transistor 38, while the inverse signal from input d1' passes through transistor 16 and is fed to the base of bipolar transistor 26 and to the gate of nMOS transistor 34. If the signal at the d1 input is high, bipolar transistor 22 is turned on, and the output r goes high, while bipolar transistor 26 is turned off and nMOS transistor 38 is turned on driving inverting output r' quickly low (towards the voltage at its source).

It will be appreciated that when d1 is selected and high, the high voltage is applied to the gate of pMOS transistor 47 keeping it off. Thus, nMOS transistor 38 which is on is permitted to control the output voltage at the inverting output r'. Also, with input d1 selected and high, input d1' is selected and low, and the low voltage is applied to gate pMOS transistor 43, turning it on, and to the gate of nMOS transistor 34, keeping it off. When pMOS transistor 43 turns on, the voltage Vcc at its source is transferred to its drain, thereby pulling up the base of npn bipolar transistor 22 all the way up to the high voltage rail. Thus, the voltage at output r is pulled up to Vcc - Vbe, where Vbe is the standard base-emitter voltage drop of a bipolar transistor when it just turns on.

When input d1 is selected and low, the low voltage is applied to the base of npn transistor 22, to the gate of pMOS transistor 47, and to the gate of nMOS transistor 38. Also, with input d1 selected and low, input d1' is selected and high, and the high voltage is applied to the base of npn transistor 26, to the gate of pMOS transistor 43, and to the gate of nMOS transistor 34. As a result, bipolar transistor 22 and pMOS transistor 43 turn off while pull-down nMOS transistor 34 turns on, and the voltage at the noninverting output is controlled by the nMOS transistor 34; i.e. it is pulled low. Conversely, bipolar transistor 26 quickly turns on, followed by pMOS transistor 47 turning on, while nMOS transistor 38 turns off. As a result, the voltage at the inverting output r' is quickly pulled high by npn pull-up transistor 26, and then is pulled all the way up to Vcc - Vbe because of pMOS pull-up transistor 47 turning on.

When the select input S goes low, and the select input S' goes high, pass gate nMOS transistors 12 and 16 are turned on while pass gate nMOS transistors 14 and 18 are turned off. As a result, inputs d0 and d0' are selected. Because the sources of pass gate nMOS transistors 12 and 14 are connected, as are the sources of pass gate nMOS transistors 16 and 18, the voltages at of inputs d0 and d0' are applied to bipolar transistors 22 and 26, nMOS transistors 34 and 38, and pMOS transistors 43 and 47 in the exact same manner discussed above with reference to inputs d1 and d1'. As a result, it will be appreciated that a differential input, differential output multiplexer with high output drive, and controlled by a differential select input is obtained.

By taking the multiplexer 10 of Figure 1, and coupling the d1 input to the d0' input, and the d1' to do the input, an XOR/XNOR gate is created if the coupled inputs act as a first differential input, and the select inputs are taken as the second differential input of the circuit. This arrangement is seen in Figure 2 where the coupled d1 and d0' inputs are called the A input, the coupled d0 and d1' inputs are called the A' input, and the select inputs (S and S') are called the P and B' inputs. The differential outputs of the XOR/XNOR gate are called t and t', with t providing the logical output A XNOR B, and t' providing a XOR B. The circuitry of Figure 2 is identical to that of Figure 1 except for the coupled inputs, and the transistors are accordingly numbered except that they have numbers one hundred higher.

In operation, when A and B are low, A' and B' are high. Thus, nMOS transistors 114 and 118 are turned on, and a high voltage is generated at the source of transistor 114, while a low voltage is generated at the source of transistor 118. With a high voltage at the source of transistor 114, as discussed above with reference to Fig. 1, transistor 122 will turn on pulling the noninverting (XNOR) output t high, while transistor 126 will turn off and nMOS transistor 138 will turn on, pulling the inverting (XOR) output t' low.

When A is high and B is low, A' is low and B' is high. Thus, nMOS transistors 114 and 118 are turned on, and a low voltage is generated at the source of transistor 114, while a high voltage is generated at the source of transistor 118. With a low voltage at the source of transistor 114, as discussed above with reference to Fig. 1, transistor 122 will turn off and transistor 134 will turn on pulling the noninverting output t low, while transistor 138 will turn off and npn transistor 138 will turn on (because of the high voltage at the source of transistor 118), pulling the inverting output t' high.

When A is low and B is high, A' is high and B' is low. Thus, transistors 112 and 116 are turned on, and a low voltage is generated at the source of transistor 112, while a high voltage is generated at the source of transistor 116. With a low voltage at the source of transistor 112, and a high voltage at the source of transistor 116, transistor 122 will turn off and transistor 134 will turn on pulling the noninverting output t low. Also, with a high voltage at the source of transistor 116, transistor 126 will turn on, pulling the inverting output t' high.

When A is high and B is high, A' is low and B' is low. Thus, transistors 112 and 116 are turned on, and a high voltage is generated at the source of transistor 112, while a low voltage is generated at the source of transistor 116. With a high voltage at the source of transistor 112, npn transistor 122 will turn on pulling the noninverting output t high. Also, nMOS transistor 138 will be turned on and pull the inverting output t' low, as the low voltage at the source of transistor 116 will turn transistor 126 off.

A review of the above reveals that gate 110 is governed by the following truth table:

| A | A' | B | B' | t | t' |
|---|---|---|---|---|---|
| 0 | 1 | 0 | 1 | 1 | 0 |
| 1 | 0 | 0 | 1 | 0 | 1 |
| 0 | 1 | 1 | 0 | 0 | 1 |
| 1 | 0 | 1 | 0 | 1 | 0 |

Clearly, the t output is the logical output of A XNOR B, while the t' output is the logical output of A XOR B. Thus, an XOR/XNOR gate is established.

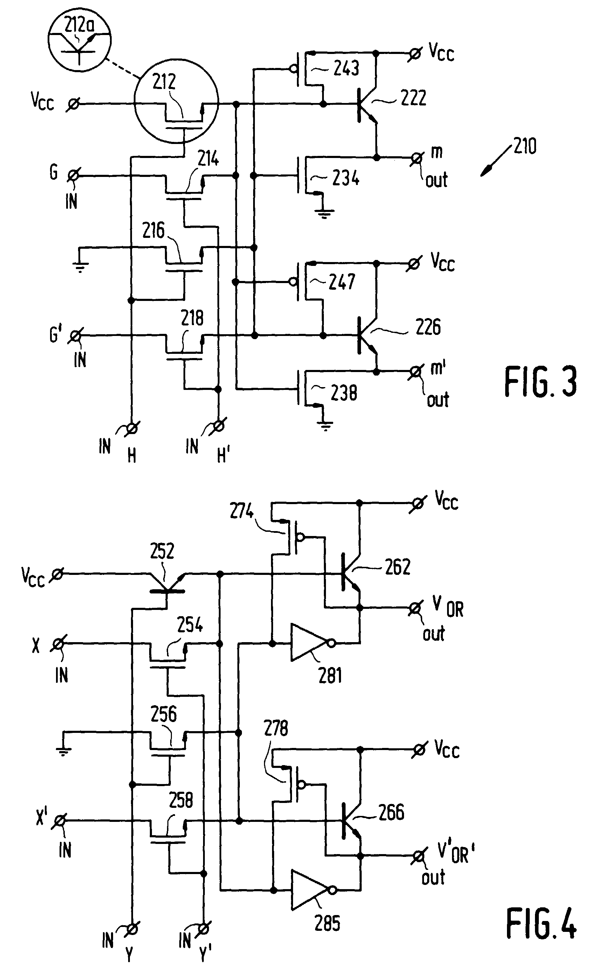

Turning to Figure 3, a first OR/NOR gate 210 of the invention having first and second differential inputs (G, G' and H and H') and a differential (OR/NOR) output (m and m') is seen. The transistors comprising the OR/NOR gate of Figure 3 are identical to those of the multiplexer of Figure 1 and the XOR/XNOR gate of Figure 2, with nMOS pass gates 212, 214, 216, and 218, npn bipolar pull-up transistors 222 and 226, nMOS pull-down transistors 234 and 238, and pMOS transistors 243 and 247. If desired, and as shown in phantom in Figure 3, nMOS pass gate 212 can be replaced by a bipolar npn transistor pass gate (212a). The only other differences between the OR/NOR gate and the multiplexer of Figure 1 are the inputs, and the fact that nMOS pass gate 212 has its drain coupled to the high voltage rail Vcc, while nMOS pass gate 216 has its drain coupled to the low voltage rail (ground).

In operation, when G is low and H is low, G' and H' are high. As a result, pass gate transistors 214 and 218 are turned on, and the low G voltage is transferred to the source of nMOS transistor 241, while the high G' voltage is transferred to the source of nMOS transistor 218. With the source of nMOS transistor 214 low, and the source of nMOS transistor 218 high, bipolar transistor 226 is turned on and nMOS transistor 238 is turned off, while bipolar transistor 222 is turned off and nMOS transistor 234 is turned on. With bipolar transistor 226 on and nMOS transistor 238 off, the inverted output m' is pulled high. Likewise, with bipolar transistor 222 off and nMOS transistor 234 on, noninverted output m is pulled low. It will be appreciated that with a low voltage at the source of nMOS transistor 214, pMOS transistor 247 will be turned on, and will pull the base of transistor 226 all the way up to Vcc.

When G is low and H is high, G' is high and H' is low. With H high, nMOS pass gates 212 and 216 are turned on and respectively provide high (Vcc) and low (ground) voltages at their respective sources. With a high voltage at the source of transistor 212, bipolar transistor 222 and nMOS transistor 238 turn on, while with a low voltage at the source of transistor 216, bipolar transistor 226 and nMOS transistor 234 turn off. As a result, the noninverted output m is pulled high while the inverted output m' is pulled low. This time pMOS transistor 247 is turned off to prevent dissipation of current from Vcc to ground, and thereby providing zero static power usage.

It will be appreciated that when G is high and H is high, the circuit function equivalently to when G is low and H is high. That is because the nMOS pass gate transistor 212 and the nMOS pass gate transistor 216 which are coupled to the H input are not coupled directly to the G and G' inputs. Thus, regardless of the value of G, when H is high, the voltage at the base of npn transistor 222 is high and the voltage at the base of npn transistor 226 is low.

When G is high and H is low, G' is low and H' is high. As a result, transistors 214 and 218 are turned on, and the source of transistor 214 goes high while the source of transistor 218 goes low. With such a situation, the circuit 210 acts identically to the situation where H is high, and the noninverting m output goes high, while the inverting m' output goes low.

A review of the above reveals that gate 210 is governed by the following truth table:

| G | G' | H | H' | m | m' |
|---|---|---|---|---|---|
| 0 | 1 | 0 | 1 | 0 | 1 |
| 1 | 0 | 0 | 1 | 1 | 0 |
| 0 | 1 | 1 | 0 | 1 | 0 |
| 1 | 0 | 1 | 0 | 1 | 0 |

Clearly, the m output is the logical output of G or H, while the m' output is the logical output of G NOR H. Thus, an OR/NOR gate is established. It will also be appreciated that according to DeMorgan's theorem, a differential OR gate becomes a differential NAND gate when the inverting and noninverting inputs of the differential signals are switched (e.g. the G input signal is applied to the G' input node; the G' input signal is applied to the G input node; the H input signal is applied to the H' input node; and the H' input signal is applied to the H input node). Likewise, a NOR gate becomes an AND gate when the inverting and noninverting inputs of the differential signals are switched. Hence, OR/NOR gate of Figure 3 may also be used as an AND/HAND gate.

A second OR/NOR gate 250 of the invention having first and second differential inputs (X, X', and Y and Y') and a differential (OR/NOR) output (v and v') is seen in Figure 4. The OR/NOR gate utilizes two nMOS pass gate transistors 254 and 258, a bipolar transistor 252 tied to the high voltage rail Vcc (although an nMOS transistor could be substituted therefor), an nMOS transistor 256 tied to the low voltage rail, two pull-up npn bipolar transistors 262 and 266, and two pMOS transistors 274 and 278, and two inverters 281 and 285.

The OR/NOR gate 210 has the noninverted and inverted inputs X and X' coupled to drains of the two nMOS pass gates 254 and 258. The drain of nMOS transistor 256 is coupled to the low voltage rail, while the collector of npn bipolar transistor 252 is coupled to the high voltage rail Vcc. The base of bipolar transistor 252 and the gate of nMOS transistor 256 are coupled to noninverting input Y, while the gates of the nMOS pass gates 254 and 258 are coupled to the inverting input Y'. The emitter of bipolar transistor 252 and the source of nMOS pass gate 254 are both coupled to the base of a first pull-up npn bipolar transistor 262, while the sources of nMOS transistor 256 and nMOS pass gate transistor 258 are coupled to the base of a second pull-up bipolar transistor 266. The noninverting (OR) output of logic gate 210 is taken from the emitter of npn bipolar transistor 262, while the inverting (NOT) output of logic gate 210 is taken from the emitter of npn bipolar transistor 266.

Both pull-up bipolar transistors 262 and 266 have their collectors coupled to the high voltage rail. Coupled to the collector of transistor 262 is the source of pMOS transistor 274, whose gate is coupled to the emitter of bipolar transistor 262. The drain of pMOS transistor 274 is coupled to the sources of nMOS transistors 256 and 258 and is coupled to the input of inverter 281. Inverter 281 is preferably a standard CMOS inverter, and the inverted output from inverter 281 is coupled to the gate of pMOS transistor 274. Similarly, coupled to the collector of transistor 266 is the source of pMOS transistor 278, whose gate is coupled to the emitter of bipolar transistor 266. The drain of pMOS transistor 278 is coupled to the source of nMOS transistor 254 and the collector of bipolar transistor 252. The drain of pMOS transistor 278 is also coupled to the input of inverter 285, whose inverted output is coupled to the gate of pMOS transistor 278.

In operation, when X is low and Y is low, X' and Y' are high. As a result, pass gate transistors 254 and 258 are turned on, and the low X voltage is transferred to the source of nMOS transistor 254, while the high X' voltage is transferred to the source of nMOS transistor 258. With the source of nMOS transistor 254 low, and the source of nMOS transistor 258 high, bipolar transistor 266 is turned on while bipolar transistor 262 is turned off. With bipolar transistor 262 on, the inverted output v' goes high. Also, with the source of nMOS transistor 258 high, inverter 281 provides a low voltage to the noninverted output v. The low voltage supplied by the inverter 281 is also applied to the gate of pMOS transistor 274 which turns pMOS transistor 274 on. With pMOS transistor 274 on, the voltage at the input to inverter 281 is brought to Vcc, thereby guaranteeing that the voltage at the output of inverter 281 which also serves as the noninverting output voltage is as low as possible. Similarly, with the source of nMOS transistor 254 low, inverter 285 provides a high output which pulls the high voltage at the emitter of bipolar transistor 266 even higher. As a result bipolar transistor 266 turns off, and inverter 285 is used to keep v' high. Thus, the high v' output is maintained with zero static power.

When X is low and Y is high, X' is high and Y' is low. With Y high, npn transistor 252 and nMOS transistor 256 are turned on and respectively provide high (Vcc - Vbe) and low (ground) voltages at their respective emitter and source. With the emitter of transistor 252 high, inverter 285 quickly provides a low voltage at inverting output v'. Bipolar transistor 266 is unable to keep the v' output high, as the voltage at its gate is low due to npn transistor 256. As the inverting output voltage goes low, pMOS transistor 278 is turned on and pulls the voltage at the input of inverter 285 all the way up to Vcc. In turn, inverter 285 provides an even lower voltage to the inverting output v'. Conversely, when the voltage at the emitter of transistor 252 goes high, it quickly turns on npn transistor 262 which provides a high voltage (Vin - 2Vbe) at the noninverting output v. Also, with the source of nMOS transistors 256 at ground, inverter 281 provides a high voltage signal which pulls the noninverting output v from vin - 2Vbe up to its maximum. As the voltage at the v output is pulled above the base voltage of transistor 262, transistor 262 is turned off.

It will be appreciated that when X is high and Y is high, the circuit function equivalently to when X is low and Y is high. That is because the npn transistor 252 and the nMOS transistor 256 which are coupled to the Y input are not coupled directly to the X and X' inputs. Thus, regardless of the value of X, when Y is high, the voltage at the base of npn transistor 262 is high and the voltage at the base of npn transistor 266 is low.

When X is high and Y is low, X' is low and Y' is high. As a result, transistors 254 and 258 are turned on, and the source of transistor 254 goes high while the source of transistor 258 goes low. With such a situation, the circuit 210 acts identically to the situation where Y is high, and the noninverting v output goes high, while the inverting v' output goes low.

A review of the above reveals that gate 250 is governed by the following truth table:

| X | X' | Y | Y' | v | v' |
|---|---|---|---|---|---|
| 0 | 1 | 0 | 1 | 0 | 1 |
| 1 | 0 | 0 | 1 | 1 | 0 |
| 0 | 1 | 1 | 0 | 1 | 0 |
| 1 | 0 | 1 | 0 | 1 | 0 |

Thus, a second OR/NOR gate is established.

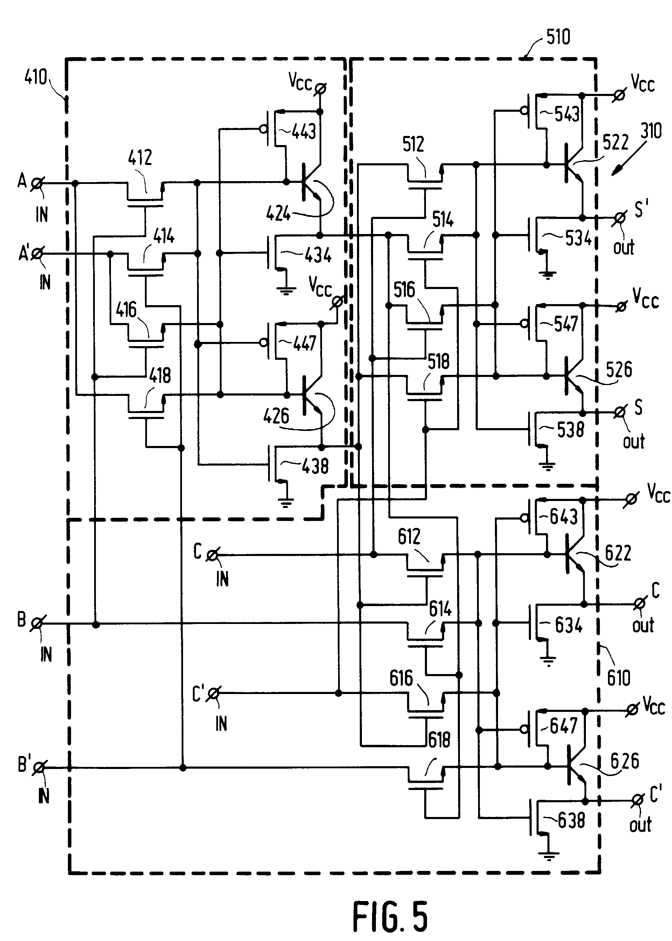

Turning to Figure 5, a one bit full adder with carry in and carry out 310 is provided and is comprised of two sets of XOR/XNOR gates 410 and 510 such as shown in Figure 2, and a multiplexer 610 such as shown in Figure 1. XOR/XNOR gate 410 has transistors 412, 414, 416, 418, 422, 426, 434, 438, 443, and 447, while XOR/XNOR gate 510 has transistors 512, 514, 516, 518, 522, 526, 534, 538, 543, and 547. Multiplexer 610 has transistors 612, 614, 616, 618, 622, 626, 634, 638, 643, and 647. The XOR/XNOR gate 410 takes two differential inputs (A and A', B and B') and provides a first differential output (t and t') at the emitters of transistors 422 and 426. The first differential output is used as one differential input to the second XOR/XNOR gate 510, while the carry in differential input (c and c') is used as a second differential input to the second XOR/XNOR gate 510 which provide a second differential output (s' and s) at the emitters of npn transistors 522 and 526. The noninverting output s of the second differential output is taken as the binary sum of A + B + C (i.e. S goes high when an odd number of A, B and c are high), while the inverting output s' is the inverse of the sum. The multiplexer 610 uses the first differential output (t and t') from XOR/XNOR gate 410 as the differential select input which multiplexes the second differential input (B and B') and the carry in differential input (c and c'). The noninverting output C of the multiplexer 610 provided at the emitter of npn transistor 622 is taken as the carry out, while the inverting output C' of the multiplexer 610 taken at the emitter of npn transistor 626 is the inverse of the carry out. The noninverting carry out output C goes high when two or more of A, B, and c are high.

There have been described and illustrated herein differential input, differential output BiCMOS multiplexers, logic gates, and adders. While particular embodiments have been described, it is not intended that the invention be limited thereto, as it is intended that the invention be broad in scope as the art will allow. Thus, for example, while the use of npn bipolar transistors was disclosed in conjunction with advantageous location of nMOS and pMOS transistors, it will be appreciated that pnp bipolar transistors as well as substitution of pMOS for nMOS transistors and vice versa could be effectively utilized with minor changes which would be apparent to those skilled in the art. Further, it will be appreciated that while pMOS transistors were utilized in Figures 1-3 and 5 both for their ability to pull the voltage at the base of the npn transistors up to Vcc, and for their ability to create a CMOS circuit with zero static power, that resistors could be utilized in their place. While a circuit with resistors instead of the pMOS transistors would consume power, they still could be effective in providing a desired differential output.

## Claims

1. An electronic circuit comprising:
a) first, second, third and fourth pass gates (12, 14, 16, 18), each having first and second flow electrodes and a control electrode for controlling current flow between the first and second electrodes, with the first electrodes of said first and third pass gates (12, 16) being responsive to a first differential input signal, the first electrodes of said second and fourth pass gates (14, 18) being responsive to a second differential input signal, the control electrodes of said first and third pass gates (12, 16) being responsive to a first pole of a third differential input signal, and the control of said second and fourth pass gates (14, 18) being responsive to a second pole of the third differential input signal;
b) first and second bipolar transistors (22, 26), each having a collector, a base, and an emitter, with the base of said first bipolar transistor (22) coupled to the second electrodes of said first and second pass gates (12, 14), the base of said second bipolar transistor (26) coupled to the second electrode of said third and fourth pass gates (16, 18), and the collectors of the first and second bipolar transistors (22, 26) being coupled to a first power supply terminal (V_{cc});
c) first and second FETs (34, 38) of a first polarity, each having a drain, a gate electrode, and a source, with their drains respectively coupled to the emitters of said first and second bipolar transistors (22, 26), the gate electrodes of said first FET (34) coupled to the second electrodes of said third and fourth pass gates (16, 18), the gate electrodes of said second FET (38) coupled to the second electrodes of said first and second pass gates (12, 14), the source electrodes of said first and second FETs (34, 38) being coupled to a second power supply terminal, the emitters of said first and second bipolar transistors (22, 26) supplying a differential output signal.

2. A circuit according to Claim 1 wherein each pass gate (12, 14, 16, 18) comprises a FET.

3. A circuit according to Claim 1 wherein said first pass gate (12, 212) comprises either a bipolar transistor (212) or a FET (12), and each other pass gate comprises a FET.

4. A circuit according to Claim 1 wherein said bipolar transistors (22, 26) are of like polarity.

5. A circuit according to Claim 1 wherein the circuit functions as a multiplexer, the third differential input signal being a differential select signal.

6. A circuit according to Claim 1 wherein the first flow electrodes of said fourth and third pass gates (18, 16) are respectively coupled to the first flow electrodes of said first and second pass gates (12, 14) said circuit functioning as a XOR/XNOR logic gate, the differential output signal being the logic XOR/XNOR of the first and third differential input signals.

7. A circuit according to Claim 5 or 6 wherein each pass gate (12, 14, 16, 18) comprises a FET having first and second source/drain elements and a gate electrode that respectively are the first, second and control electrodes of that gate.

8. A circuit according to Claim 1 wherein the first flow elements of said first and third pass gates (212, 216) are respectively coupled to first and second voltage rails, said circuit functioning as an OR/NOR logic gate, the differential output signal being the logic OR/NOR of the second and third differential input signals.

9. A circuit according to Claim 1 including first and second FETs (43, 47) of a second polarity opposite to said first polarity, each having a drain, a gate electrode, and a source, with their drains respectively coupled to the bases of said second and first bipolar transistors (22, 26), and their gate electrodes respectively coupled to the emitters of said first and second bipolar transistors (22, 26).

10. A circuit according to Claim 9 including third and fourth FETs of the second polarity, each having a drain, a gate electrode, and a source, with their drains respectively coupled to the emitters of said first and second bipolar transistors (262, 266), the gate electrode of said third FET of the second polarity coupled to the second electrodes of said third and fourth pass gates (256, 258), the gate electrode of said fourth FET of the second polarity coupled to the second electrodes of said first and second pass gates (254, 252), and the source electrodes of said third and fourth FET of the second polarity being coupled to the first power supply terminal.

11. A circuit according to Claim 10 wherein the first flow elements of said first and third pass gates (252, 256) are respectively coupled to first and second voltage rails, said circuit functioning as an OR/NOR logic gate.

12. A circuit according to Claim 8 or 11 wherein said first pass gate (252, 212) either comprises a bipolar transistor having a collector, an emitter, and a base that respectively are the first, second, and control electrodes of that gate or comprises a FET having first and second source/drain elements and a gate electrode that respectively are the first, second, and control electrodes of that gate, and each other pass gate comprises a FET having first and second source/drain elements and a gate electrode that respectively are the first, second, and control electrodes of that gate.

13. A circuit according to Claim 1 functioning as a full one bit adder with carry in and carry out, wherein the circuit comprises a first and a second XOR/XNOR gate according to Claim 7 and comprises a multiplexer according to Claim 5.

14. A circuit according to Claim 13, wherein the first XOR/XNOR gate receives a first and a second differential summand signal, the second XOR/XNOR gate receives the differential output signal of the first XOR/XNOR gate and a differential carry input signal of the circuit, and the multiplexer receives as its first differential input signal the differential carry input signal of the circuit and as its second differential input signal the second differential summand signal, the differential output signal of the second XOR/XNOR gate being the differential sum output signal of the circuit and the differential output signal of the multiplexer being the differential carry output signal of the circuit.

## Patentansprüche

1. Elektronische Schaltung, die folgendes enthält:
a) erste, zweite, dritte und vierte Durchlaßgatter (12, 14, 16, 18) mit jeweils einer ersten und einer zweiten Leitungselektrode und einer Steuerelektrode zum Steuern des Stromflusses zwischen der ersten und der zweiten Elektrode, wobei die ersten Elektroden des genannten ersten und des genannten dritten Durchlaßgatters (12, 16) auf ein erstes differentielles Eingangssignal reagieren und die ersten Elektroden des genannten zweiten und des genannten vierten Durchlaßgatters (14, 18) auf ein zweites differentielles Eingangssignal reagieren, und wobei die Steuerelektroden des genannten ersten und des genannten dritten Durchlaßgatters (12, 16) auf einen ersten Pol eines dritten differentiellen Eingangssignals reagieren und die Steuerelektroden des genannten zweiten und des genannten vierten Durchlaßgatters (14, 18) auf einen zweiten Pol des dritten differentiellen Eingangssignals reagieren;
b) erste und zweite Bipolartransistoren (22, 26) mit jeweils einem Kollektor, einer Basis und einem Emitter, wobei die Basis des genannten ersten Bipolartransistors (22) mit der zweiten Elektrode des genannten ersten und des genannten zweiten Durchlaßgatters (12, 14) verbunden ist, die Basis des genannten zweiten Bipolartransistors (26) mit der zweiten Elektrode des genannten dritten und des genannten vierten Durchlaßgatters (16, 18) verbunden ist und die Kollektoren des ersten und des zweiten Bipolartransistors (22, 26) mit einem ersten Stromversorgungsanschluß (V_{cc}) verbunden sind;
c) erste und zweite FETs (34, 38) von einer ersten Polarität mit jeweils einer Drain-Elektrode, einer Gate-Elektrode und einer Source-Elektrode, wobei die Drain-Elektroden jeweils mit den Emittern des genannten ersten bzw. des genannten zweiten Bipolartransistors (22, 26) verbunden sind, die Gate-Elektroden des genannten ersten FET (34) mit der zweiten Elektrode des genannten dritten und des genannten vierten Durchlaßgatters (16, 18) verbunden sind, die Gate-Elektroden des genannten zweiten FET (38) mit der zweiten Elektrode des genannten ersten und des genannten zweiten Durchlaßgatters (12, 14) verbunden sind, die Source-Elektroden des genannten ersten und des genannten zweiten FET (34, 38) mit einem zweiten Stromversorgungsanschluß verbunden sind und die Emitter des ersten und des zweiten Bipolartransistors (22, 26) ein differentielles Ausgangssignal liefern.

2. Schaltung nach Anspruch 1, wobei jedes Durchlaßgatter (12, 14, 16, 18) einen FET enthält.

3. Schaltung nach Anspruch 1, wobei das genannte erste Durchlaßgatter (12, 212) entweder einen Bipolartransistor (212) oder einen FET (12) enthält und jedes andere Durchlaßgatter einen FET enthält.

4. Schaltung nach Anspruch 1, wobei die genannten Bipolartransistoren (22, 26) die gleiche Polarität haben.

5. Schaltung nach Anspruch 1, wobei die Schaltung als Multiplexer funktioniert und das dritte differentielle Eingangssignal ein differentielles Auswahlsignal ist.

6. Schaltung nach Anspruch 1, wobei die erste Leitungselektrode des genannten vierten und des genannten dritten Durchlaßgatters (18, 16) jeweils mit der ersten Leitungselektrode des genannten ersten und des genannten zweiten Durchlaßgatters (12, 14) verbunden ist und die genannte Schaltung als logisches XOR/XNOR-Gatter funktioniert, wobei das differentielle Ausgangssignal die logische XOR/XNOR-Verknüpfung des ersten und des dritten differentiellen Eingangssignals ist.

7. Schaltung nach Anspruch 5 oder 6, wobei jedes Durchlaßgatter (12, 14, 16, 18) einen FET mit einem ersten und einem zweiten Source/Drain-Element und einer Gate-Elektrode enthält, die die erste, die zweite bzw. die Steuerelektrode dieses Gatters darstellen.

8. Schaltung nach Anspruch 1, wobei das erste Leitungselement des genannten ersten und des genannten dritten Durchlaßgatters (212, 216) jeweils mit einer ersten und einer zweiten Spannungsschiene verbunden ist und wobei die Schaltung als logisches OR/NOR-Gatter funktioniert und das differentielle Ausgangssignal die logische OR/NOR-Verknüpfung des zweiten und des dritten differentiellen Eingangssignals ist.

9. Schaltung nach Anspruch 1 mit einem ersten und einem zweiten FET (43, 47) einer zweiten Polarität, die der genannten ersten Polarität entgegengesetzt ist, und mit einer Drain-Elektrode, einer Gate-Elektrode und einer Source-Elektrode, wobei die Drain-Elektrode jeweils mit der Basis-Elektrode des genannten zweiten und des genannten ersten Bipolartransistors (22, 26) verbunden ist und die Gate-Elektrode jeweils mit dem Emitter des genannten ersten und des genannten zweiten Bipolartransistors (22, 26) verbunden ist.

10. Schaltung nach Anspruch 9 mit einem dritten und einem vierten FET der zweiten Polarität mit jeweils einer Drain-Elektrode, einer Gate-Elektrode und einer Source-Elektrode, wobei die Drain-Elektrode jeweils mit dem Emitter des genannten ersten bzw. des genannten zweiten Bipolartransistors (262, 266) verbunden ist, die Gate-Elektrode des genannten dritten FET der zweiten Polarität mit der zweiten Elektrode des genannten dritten und des genannten vierten Durchlaßgatters (256, 258) verbunden ist, die Gate-Elektrode des genannten vierten FET der zweiten Polarität mit der zweiten Elektrode des genannten ersten und des genannten zweiten Durchlaßgatters (254, 252) verbunden ist und die Source-Elektrode des genannten dritten und des genannten vierten FET der zweiten Polarität mit dem ersten Stromversorgungsanschluß verbunden ist.

11. Schaltung nach Anspruch 10, wobei das erste Leitungselement des genannten ersten und des genannten dritten Durchlaßgatters (252, 256) jeweils mit einer ersten bzw. einer zweiten Spannungsschiene verbunden sind und wobei die Schaltung als logisches OR/NOR-Gatter funktioniert.

12. Schaltung nach Anspruch 8 oder 11, wobei das genannte erste Durchlaßgatter (252, 212) entweder einen Bipolartransistor mit Kollektor, Emitter und Basis enthält, die die erste, die zweite bzw. die Steuerelektrode dieses Gatters darstellen, oder einen FET mit einem ersten und einem zweiten Source/Drain-Element und einer Gate-Elektrode, die die erste, die zweite bzw. die Steuerelektrode dieses Gatters darstellen, und wobei jedes andere Durchlaßgatter einen FET mit einem ersten und einem zweiten Source/Drain-Element und einer Gate-Elektrode enthält, die die erste, die zweite bzw. die Steuerelektrode dieses Gatters darstellen.

13. Schaltung nach Anspruch 1, die als Ein-Bit-Volladdierer mit Eintrag und Austrag funktioniert, wobei die Schaltung ein erstes und ein zweites XOR/XNOR-Gatter nach Anspruch 7 und einen Multiplexer nach Anspruch 5 enthält.

14. Schaltung nach Anspruch 13, wobei das erste XOR/XNOR-Gatter ein erstes und ein zweites differentielles Summanden-Signal empfängt, das zweite XOR/XNOR-Gatter das differentielle Ausgangssignal des ersten XOR/XNOR-Gatters und ein differentielles Übertrag-Eingangssignal der Schaltung empfängt, der Multiplexer als erstes differentielles Eingangssignal das differentielle Übertrag-Eingangssignal der Schaltung empfängt und als zweites differentielles Eingangssignal das zweite differentielle Summanden-Signal, wobei das differentielle Ausgangssignal des zweiten XOR/XNOR-Gatters das differentielle Summen-Ausgangssignal der Schaltung ist und das differentielle Ausgangssignal des Multiplexers das differentielle Übertrag-Ausgangssignal der Schaltung ist.

## Revendications

1. Circuit électronique comprenant :
a) des première, deuxième, troisième et quatrième portes de régulation (12, 14, 16, 18), ayant chacune une première et une deuxième électrodes de passage et une électrode de commande pour commander le passage du courant entre la première et la deuxième électrodes, les premières électrodes desdites première et troisième portes de régulation (12, 16) réagissant à un premier signal d'entrée différentielle, les premières électrodes desdites deuxième et quatrième portes de régulation (14, 18) réagissant à un deuxième signal d'entrée différentielle, les électrodes de commande desdites première et troisième portes de régulation (12, 16) réagissant à un premier pôle d'un troisième signal d'entrée différentielle, et la commande desdites deuxième et quatrième portes de régulation (14, 18) réagissant à un deuxième pôle du troisième signal d'entrée différentielle;
b) des premier et deuxième transistors bipolaires (22, 26), ayant chacun un collecteur, une base et un émetteur, la base dudit premier transistor bipolaire (22) étant couplée aux deuxièmes électrodes desdites première et deuxième portes de régulation (12, 14), la base dudit deuxième transistor bipolaire (26) étant couplée à la deuxième électrode desdites troisième et quatrième portes de régulation (16, 18), et les collecteurs des premier et deuxième transistors bipolaires (22, 26) étant couplés à une première borne d'alimentation (Vcc);
c) des premier et deuxième FET (34, 38) d'une première polarité, ayant chacun un drain, une électrode de grille et une source, leurs drains étant respectivement couplés aux émetteurs desdits premier et deuxième transistors bipolaires (22, 26), l'électrode de grille dudit premier FET (34) étant couplée aux deuxièmes électrodes desdites troisième et quatrième portes de régulation (16, 18), l'électrode de grille dudit deuxième FET (38) étant couplée aux deuxièmes électrodes desdites première et deuxième portes de régulation (12, 14), les électrodes de source desdits premier et deuxième FET (34, 38) étant couplées à une deuxième borne d'alimentation, les émetteurs desdits premier et deuxième transistors bipolaires (22, 26) fournissant un signal de sortie différentielle.

2. Circuit suivant la revendication 1, dans lequel chaque porte de régulation (12, 14, 16, 18) comprend un FET.

3. Circuit suivant la revendication 1, dans lequel ladite première porte de régulation (12, 212) comprend soit un transistor bipolaire (212) soit un FET (12), et chaque autre porte de régulation comprend un FET.

4. Circuit suivant la revendication 1, dans lequel lesdits transistors bipolaires (22, 26) sont de même polarité.

5. Circuit suivant la revendication 1, dans lequel le circuit fonctionne comme un multiplexeur, le troisième signal d'entrée différentielle étant un signal de sélection différentielle.

6. Circuit suivant la revendication 1, dans lequel les premières électrodes de passage desdites quatrième et troisième portes de régulation (18, 16) sont respectivement couplées aux premières électrodes de passage desdites première et deuxième portes de régulation (12, 14), ledit circuit fonctionnant comme une porte logique OU exclusif/NI exclusif, le signal de sortie différentielle étant le OU exclusif/NI exclusif logique des premier et troisième signaux d'entrée différentielle.

7. Circuit suivant la revendication 5 ou 6, dans lequel chaque porte de régulation (12, 14, 16, 18) comprend un FET ayant des premier et deuxième éléments source-drain et une électrode de grille, qui sont respectivement la première électrode, la deuxième électrode et l'électrode de commande de cette porte.

8. Circuit suivant la revendication 1, dans lequel les premiers éléments de passage desdites première et troisième portes de régulation (212, 216) sont respectivement couplés aux première et deuxième lignes de tension, ledit circuit fonctionnant comme une porte logique OU/NI, le signal de sortie différentielle étant le OU/NI logique des deuxième et troisième signaux d'entrée différentielle.

9. Circuit suivant la revendication 1, comprenant des premier et deuxième FET (43, 47) d'une deuxième polarité opposée à ladite première polarité, ayant chacun un drain, une électrode de grille, et une source, leurs drains étant couplés respectivement aux bases desdits deuxième et premier transistors bipolaires (22, 26), et leurs électrodes de grille étant couplées respectivement aux émetteurs desdits premier et deuxième transistors bipolaires (22, 26).

10. Circuit suivant la revendication 9, comprenant des troisième et quatrième FET de la deuxième polarité, ayant chacun un drain, une électrode de grille et une source, leurs drains étant couplés respectivement aux émetteurs desdits premier et deuxième transistors bipolaires (262, 266), l'électrode de grille dudit troisième FET de la deuxième polarité étant couplée aux deuxièmes électrodes desdites troisième et quatrième portes de régulation (256, 258), l'électrode de grille dudit quatrième FET de la deuxième polarité étant couplée aux deuxièmes électrodes desdites première et deuxième portes de régulation (254, 252), et les électrodes de sources desdits troisième et quatrième FET de la deuxième polarité étant couplées à la première borne d'alimentation.

11. Circuit suivant la revendication 10, dans lequel les premiers éléments de passage desdites première et troisième portes de régulation (252, 256) sont respectivement couplés aux première et deuxième lignes de tension, ledit circuit fonctionnant comme une porte logique OU/NI.

12. Circuit suivant la revendication 8 ou 11, dans lequel ladite première porte de régulation (252, 212) comprend un transistor bipolaire ayant un collecteur, un émetteur et une base, qui sont respectivement la première électrode, la deuxième électrode et l'électrode de commande de cette porte, ou comprend un FET ayant des premier et deuxième éléments source-drain et une électrode de grille, qui sont respectivement la première électrode, la deuxième électrode et l'électrode de commande de cette porte, et chaque autre porte de régulation comprend un FET ayant des premier et deuxième éléments source-drain et une électrode de grille, qui sont respectivement la première électrode, la deuxième électrode et l'électrode de commande de cette porte.

13. Circuit suivant la revendication 1, fonctionnant comme un additionneur complet à un bit avec report en entrée et report en sortie, dans lequel le circuit comprend une première et une deuxième portes OU exclusif/NI exclusif suivant la revendication 7 et comprend un multiplexeur suivant la revendication 5.

14. Circuit suivant la revendication 13, dans lequel la première porte OU exclusif/NI exclusif reçoit un premier et un deuxième signaux d'opérande de somme différentiels, la deuxième porte OU exclusif/NI exclusif reçoit le signal de sortie différentielle de la première porte OU exclusif/ NI exclusif et un signal d'entrée de report différentielle du circuit, et le multiplexeur reçoit comme premier signal d'entrée différentielle le signal d'entrée de report différentielle du circuit et comme deuxième signal d'entrée différentielle le deuxième signal d'opérande de somme différentiel, le signal de sortie différentielle de la deuxième porte OU exclusif/NI exclusif étant le signal de sortie de somme différentielle du circuit et le signal de sortie différentielle du multiplexeur étant le signal de sortie de report différentielle du circuit.
